(19) **Europäisches Patentamt**
**European Patent Office**
**Office européen des brevets**

(11) **EP 4 715 775 A1**

(12) **EUROPÄISCHE PATENTANMELDUNG**

(43) Veröffentlichungstag:
25.03.2026 Patentblatt 2026/13

(21) Anmeldenummer: 25203269.3

(22) Anmeldetag: 19.09.2025

(51) Internationale Patentklassifikation (IPC):
***G08B 21/02*** *(2006.01)*

(52) Gemeinsame Patentklassifikation (CPC):
**G08B 21/02;** G01R 29/085

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH LA MA MD TN**

(30) Priorität: **23.09.2024 AT 507732024**

(71) Anmelder: **Adaptive Regelsysteme Gesellschaft
m.b.H.
5020 Salzburg (AT)**

(72) Erfinder:
• **Klapper, Ulrich
6830 Rankweil (AT)**
• **Altenbuchner, Michael
5020 Salzburg (AT)**

(74) Vertreter: **Patentanwälte Pinter & Weiss OG
Prinz-Eugen-Straße 70
1040 Wien (AT)**

(54) **WARNVORRICHTUNG ZUM ERKENNEN EINER ANNÄHERUNG AN EINE ELEKTRISCHE ANLAGE**

(57) Die Erfindung betrifft eine Warnvorrichtung (W) zum Erkennen einer Annäherung an eine elektrische Anlage, welche zumindest eine unter Spannung stehende Komponente (K), insbesondere eine elektrische Leitung (L), aufweist, die von einem elektrischen Feld (E) umgeben ist. Dabei weist die Warnvorrichtung (W) zumindest eine Sensoreinheit (SE), welche das elektrische Feld (E) der zumindest einen Komponente (L) in ein Form eines Messsignals (M) erfasst, einen Beschleunigungssensor (BS), welcher eine Beschleunigung der Warnvorrichtung (W), vorzugsweise in einem 3-dimensionalen Raum, in Form von Beschleunigungsdaten erfasst sowie eine Auswerteeinheit (AW) auf, welche dazu eingerichtet ist, aus den vom Beschleunigungssensor (BS) erfassten Beschleunigungsdaten (BD) und aus dem von der Sensoreinheit (SE) erfassten Messsignal (M) ein jeweiliges Gefährdungspotential abzuschätzen, um zumindest eine Ausgabe von zumindest einem Warnsignal zu steuern, und aus den vom Beschleunigungssensor (BD) erfassten Beschleunigungsdaten (BS) zumindest eine jeweils aktuelle Position der Warnvorrichtung (W) in Bezug zu einer der jeweiligen aktuellen Position vorhergehende Position und eine zugehörige Veränderung des von der Sensoreinheit (SE) erfassten Messsignals (M) zu ermitteln, und aus der Veränderung des Messsignals (M) und einer Positionsveränderung der Warnvorrichtung (W) zwischen der jeweils ermittelten aktuellen Position in Bezug zur jeweils vorhergehenden Position das jeweilige Gefährdungspotential abzuschätzen.

**Fig. 1**

**Beschreibung**

Die gegenständliche Erfindung betrifft allgemeine das Gebiet der Sicherheitsausrüstungen, insbesondere den Bereich des Personenschutzes im Umfeld bzw. in der Nähe elektrischer Anlagen. Im Speziellen bezieht sich die vorliegende Erfindung auf eine Warnvorrichtung zum Erkennen einer Annäherung an eine elektrische Anlage, welche zumindest eine oder mehrere unter Spannung stehenden Komponenten, insbesondere elektrische Leitungen, aufweist, die von einem elektrischen Feld umgeben sind. Dabei weist die Warnvorrichtung zumindest eine Sensoreinheit, welche das elektrische Feld in Form eines Messsignals erfasst, sowie eine Auswerteeinheit zum Auswerten des von der Sensoreinheit erfassten Messsignals auf.

*Stand der Technik*

Elektrische Anlagen zur Energieversorgung sind weit verbreitet. Sie dienen neben der Spannungsumwandlung (z.B. Umspannwerke, Transformatorstationen, etc.), auch der Übertragung von elektrischer Energie über größere Entfernungen (z.B. elektrische Hoch- und Mittelspannungsnetze oder Abschnitte davon) sowie der Verteilung der Energie an Verbraucher (z.B. elektrische Niederspannungsnetze oder Abschnitte davon), um für die Energieversorgung von Gebäuden, für einen Maschinenpark oder eine Industrieanlage zu sorgen. Üblicherweise werden bei der Energieversorgung eine Anzahl an verschiedenen, elektrischen Anlagen eingesetzt. Elektrische Anlagen weisen üblicherweise eine Vielzahl an Komponenten auf, welche zum Wandeln von elektrischer Energie, wie z.B. Leistungstransformatoren, Schaltanlagen, etc., und/oder zum Übertragen und Verteilen von elektrischer Energie, wie z.B. Übertragungs- und Verteilleitungen (z.B. Kabel und/oder Freileitungen), Hochspannungskabelendverschlüsse, etc. verwendet werden. Derartige Komponenten führen Strom bzw. stehen unter Spannung, welche je nach Einsatzbereich der Komponente im Mittel- oder Hochspannungsbereich, wie z.B. bei Übertragungsleitungen, oder im Niederspannungsbereich, wie z.B. bei Verteilungsleitungen, liegen kann.

Die elektrischen Anlagen zur Energieversorgung mit ihren zahlreichen Komponenten, insbesondere elektrische Leitungen für die Energieübertragung und -verteilung, bedürfen einer regelmäßigen Überprüfung, Wartung und Instandhaltung, gegebenenfalls auch Erweiterung. Diese Tätigkeiten werden von entsprechenden Personen - zum Teil auch während des laufenden Betriebs der elektrischen Anlagen bzw. des Energieversorgungssystems - durchgeführt. Damit geht eine immanente Gefährdung solcher Personen einher, da im Fall einer unbeabsichtigten Annäherung in eine gefährliche Nähe an stromführende und/oder an unter Spannung stehende Komponenten, insbesondere einer elektrischen Leitung, und/oder eines unbeabsichtigten Kontakts mit derartigen Komponenten durch einen elektrischen Schlag bzw. Stromschlag Lebensgefahr oder zumindest die Gefahr von teils erheblichen Verletzungen bestehen kann. Weiterhin können sich im Umfeld einer elektrischen Anlage in der Regel auch Personen befinden, die im Falle eines falschen Verhaltens oder eines Fehlers in der elektrischen Anlage ebenfalls gefährdet sein können, z.B. einen Stromschlag zu erleiden. Ein derartiges Gefährdungspotential kann natürlich nicht nur bei elektrischen Anlagen eines Energieversorgungssystems, sondern auch bei Arbeiten (z.B. Inbetriebnahme, Wartungs- und/oder Reparaturarbeiten, Rettungsaktionen, Renovierungsarbeiten, etc.) im Umfeld oder in der Nähe von anderen Anlagen mit stromführenden und/oder unter Spannung stehenden Komponenten, wie z.B. Industrieanlagen, Produktionsmaschinen, etc., bestehen. Weiterhin kann bei Arbeiten mit Arbeitsmaschinen, wie z.B. Kränen, Bagger, etc., im Umfeld von Komponenten von elektrischen Anlagen eines Energieversorgungssystem, insbesondere in der Nähe von Übertragungsleitungen oder Verteilungsleitungen in Form Freileitungen oder Kabeln, die Gefahr bestehen, dass beispielsweise eine Arbeitsmaschine der Leitung zu nahekommt und/oder diese unbeabsichtigt beschädigt.

Üblicherweise sind z.B. in der Energiewirtschaft wie auch im industriellen Bereich Sicherheitsvorschriften und -praktiken vorgesehen, welche die Gefährdung von Personen durch elektrische Anlagen reduzieren und Unfälle mit stromführenden und/oder unter Spannung stehenden Komponenten bzw. eine Beschädigung der Komponenten durch Arbeitsmaschinen verhindern sollen. Vor allem im industriellen Bereich ist es üblich, dass elektrische Anlagen einen sogenannten Notaus aufweisen, um beispielsweise im Fall einer Berührung einer unter Spannung stehenden Komponente spannungsfrei zu schalten. Dadurch kann zwar die Sicherheit von Personen, welche im Umfeld von unter Spannung stehenden und/oder stromführenden Komponenten elektrischer Anlagen arbeiten, vor allem vor Stromschlag durch unbeabsichtigten Kontakt, erhöht werden. Es ist allerdings zumindest eine weitere Person anwesend sein, welche den Notaus im Fehlerfall auslöst und gegebenenfalls Hilfe holt. Unbeabsichtigte Beschädigungen von elektrischen Komponenten, insbesondere von Übertragungsleitungen (z.B. Freileitungen, Kabel) durch Arbeitsmaschinen werden dadurch kaum verhindert.

Eine Möglichkeit vor allem die Sicherheit von Personen zu erhöhen, welche im Umfeld bzw. in der Nähe von elektrischen Anlagen, insbesondere eines Energieversorgungssystems, arbeiten und welche daher der Gefahr einer gefährlichen Annäherung an eine unter Spannung stehende und/oder stromführende Komponente, wie z.B. einer unter Spannung stehenden Leitung, ausgesetzt sind, bieten Warnvorrichtungen. Es sind heutzutage verschiedene Warnvorrichtungen bekannt, welche für den persönlichen Gebrauch bestimmt sind und von Personen, welche z.B. im Bereich von elektrischen Anlagen arbeiten, eingesetzt werden können, um sich vor unbeabsichtigten gefährlichen Annäherungen an elektrische Komponenten und Stromschlagunfällen, vor allem in Mittel- und Hochspannungsnetzen, aber auch in Niederspannungsnetzen, zu schützen. Üblicherweise erfassen derartige Warnvorrichtungen das elektrische Feld, welches eine unter Spannung stehende Komponente, z.B. die elektrische Leitung, umgibt, wobei eine Stärke und ein Ausmaß dieses Feldes proportional zum Spannungsniveau der jeweiligen Komponente ist, oder im Falle einer Stromführung das magnetische Feld. Sie überwachen beispielsweise eine Einhaltung von Expositionsgrenzwerte für elektrische Felder und erzeugen bei Überschreiten derartiger Grenz- bzw. Schwellwerte ein Warnsignal, um z.B. eine gefährliche Annäherung und/oder einen Stromunfall zu verhindern. Idealerweise sind diese Warnvorrichtungen als kompakte, leicht von einer Person tragbare Warngeräte ausgeführt. Die Warnvorrichtung kann z.B. so ausgestaltet sein, dass sie am Handgelenk, an der Arbeitskleidung und/oder an einem Helm angebracht und getragen werden kann, um die Person bei ihren Tätigkeiten nicht behindert.

Ein derartiges Warngerät ist beispielsweise aus der EP 1 296 150 A1 bekannt, welches von einer Person z.B. auf einem Helm getragen werden kann. Dieses Warngerät besitzt ein Gehäuse, in welchem eine Sensorschaltung und eine mit der Sensorschaltung gekoppelt Alarmschaltung angeordnet sind. Die Sensorschaltung erfasst ein elektrisches Feld und erzeugt ein Signal, das proportional zur Stärke des erfassten elektrischen Felds ist. Die Alarmschaltung erzeugt ein akustisches Warnsignal, dessen Wiederholungsrate proportional zur Stärke des erfassten elektrischen Felds ist, und ein optisches Warnsignal, wobei das akustische Signal manuell stumm geschaltet werden kann und sich nach einer vorgegebenen Zeitdauer wieder aktiviert.

Ein weiteres tragbares Warngerät ist z.B. aus der EP 4 276 478 A1 bekannt, bei welcher ebenfalls mittels zweier Sensoreinheiten ein elektrisches Feld, insbesondere ein elektrisches Feld einer Hochspannungs-Leitung, erkannt wird. Dieses Warngerät gibt ein akustisches oder optisches Warnsignal aus, welches der das Warngerät tragenden Person die Stärke sowie eine generelle Richtung des erkannten elektrischen Felds anzeigt. Auch bei diesem Warngerät kann beispielsweise das akustische Warnsignal von der nutzenden Person stumm geschaltet werden, wobei sich das akustische Warnsignal ebenfalls nach einer vorgegebenen Zeitdauer wieder aktiviert.

Idealerweise sollten derartige Warngeräte eine das Warngerät tragende Person, welche sich einer unter Spannung stehenden Komponente, insbesondere einer elektrischen Leitung, annähernd zuverlässig bei einem entsprechenden Sicherheitsabstand vor einer gefährlichen Annäherung warnen. Allerdings stellt die Funktionalität dieser Warngeräte dies nicht vollständig sicher. Die vom Warngerät erfasste elektrische Feldstärke kann beispielweise in einer gefährlichen Nähe zu einer Komponente des Niederspannungsbereichs (z.B. einem Leitersystem im Bereich von 230 Volt bis ca. 1000 Volt Wechselspannung) denselben Wert aufweisen, wie in einem relativ sicheren Abstand zu einer Komponente des Mittel- oder Hochspannungsbereichs (z.B. einer elektrischen Leitung im Bereich von über ca. 1kV Wechselspannung). So kann z.B. bei einem bereits gefährlichen Abstand von ca. 20 cm von einer elektrischen Komponente im Niederspannungsbereich annähernd derselbe Feldstärkenwert (z.B. ca. 250 V/m) gemessen werden, wie beispielsweise in einem sicheren Abstand (z.B. ca. 4m) von einer elektrischen Komponente bzw. Leitung im 10kV-Mittelspannungsbereich oder in einer sehr großen Distanz (z.B. ca. 150m) von einer Hochspannungskomponente bzw. -leitung im Bereich von 420kV, wenn berücksichtigt wird, dass beispielsweise sich das elektrisches Feld aus einem Verhältnis zwischen Spannung und Abstand zur elektrischen Komponente ergibt. Bei einem unendlich langen Leiter ergibt sich das elektrische Feld beispielsweise in Abhängigkeit vom Abstand zum Leiter aus der folgenden Formel:

$$E(d) = \frac{U}{d * \ln\left(\frac{d}{R}\right)},$$

wobei E für das elektrische Feld bzw. die elektrische Feldstärke, d für einen Abstand zum Spannung führenden Leiter, U für die Spannung und R für einen Radius des elektrischen Leiters stehen.

Warngeräte, welche nur eine erfasste Feldstärke betrachten, können beispielsweise nicht zwischen einer gefährlichen Annäherung an eine Niederspannungskomponente und einem elektrischen Feld einer Mittel- bzw. Hochspannungskomponente in einem sicheren oder sogar weit entfernten Abstand unterscheiden. Bei diesen Warngeräten wird z.B. ein Alarm ausgelöst, wenn eine Feldstärke erfasst wird, welche einen vorgegebenen Schwellwert überschreitet. Es werden daher nicht selten unnötigerweise Warnsignale an einen Benutzer ausgegeben, welche dazu führen können, dass der Benutzer die Warnsignale auf stumm schaltet bzw. das Warngerät nicht verwendet. Daher werden solche Warngeräte nicht selten auf vorgegebene Spannungsbereiche eingestellt, in welchen sie zuverlässig warnen. Das kann allerdings bedeuten, dass z.B. eine Person, welche Instandhaltungs-, Wartungs-, Reparatur- und/oder Inspektionsarbeiten an elektrischen Komponenten, insbesondere an elektrischen Leitungen, durchführt, unterschiedliche für den jeweiligen Spannungsbereich passende Warngeräte mithaben und für eine Verwendung des passenden Warngeräts der jeweilige Spannungsbereich der elektrischen Komponente bekannt sein muss.

Weiterhin gibt es beispielsweise Warngeräte, wie z.B. in der WO 2018/111474 A1 beschrieben, bei welchen beispielsweise die Erkennungsempfindlichkeit und damit die Alarmierung, vor allem ein Schwellwert für der akustische Alarm, bei Ankunft bei einer elektrischen Komponente an eine in der Umgebung existierende elektrische Feldstärke angepasst werden kann. Das kann z.B. durch Drücken einer am Warngerät vorhandenen Taste durchgeführt werden. Dabei bleibt der Alarm des Warngeräts auf stillem Empfang, solange Messwerte der elektrischen Feldstärke unter diesem Wert liegen bzw. gleichbleiben, und wird erst aktiviert, sobald die gemessenen Werte den Schwellwert überschreiten bzw. die gemessene Feldstärke zunimmt. Das bedeutet, dass im schlimmsten Fall das Warngerät für jede elektrische Komponente neu eingestellt werden muss, was einen zusätzlichen Aufwand bedeutet und gegebenenfalls eine Fehlerquelle (z.B. Einstellen eines falschen Grenzwerts) und damit ein Sicherheitsrisiko darstellen kann.

Es wäre daher wünschenswert, wenn eine Warnvorrichtung bei Annäherung an eine elektrische Komponente, unabhängig von deren Spannungsbereich, zuverlässig eine gefährliche Annäherung (z.B. Unterscheiten eines jeweiligen Sicherheitsabstands) ohne zusätzlichen Aufwand und/oder ohne Gerätewechsel erkennt und dadurch die Sicherheit für einen Nutzer der Warnvorrichtung erhöht wird.

### Darstellung der Erfindung

Es ist daher die Aufgabe der gegenständlichen Erfindung, eine Warnvorrichtung anzugeben, mit der auf einfache Weise und zuverlässig eine gefährliche Annäherung an eine elektrische Komponente bzw. ein Erreichen und/oder mögliches Unterschreiten eines jeweiligen Sicherheitsabstands unabhängig vom Spannungsbereich der Komponente erkannt werden kann.

Diese Aufgabe wird durch eine Warnvorrichtung zum Erkennen einer Annäherung an eine elektrische Komponente gemäß dem unabhängigen Anspruch gelöst. Vorteilhafte Ausführungsformen der vorliegenden Erfindung sind in den abhängigen Ansprüchen beschrieben.

Erfindungsgemäß erfolgt die Lösung der Aufgabe durch eine Warnvorrichtung der eingangs angegebenen Art, wobei die Warnvorrichtung eine Sensoreinheit, welche das elektrische Feld der zumindest einen Komponente in ein Form eines Messsignals erfasst, einen Beschleunigungssensor, welcher eine Beschleunigung der Warnvorrichtung, vorzugsweise in einem 3-dimensionalen Raum, in Form von Beschleunigungsdaten erfasst, und eine Auswerteeinheit, welche dazu eingerichtet ist, aus den vom Beschleunigungssensor erfassten Beschleunigungsdaten und aus dem von der Sensoreinheit erfassten Messsignal ein jeweiliges Gefährdungspotential abzuschätzen, um zumindest eine Ausgabe von zumindest einem Warnsignal zu steuern.

Der Hauptaspekt der erfindungsgemäß vorgeschlagenen Warnvorrichtung besteht vor allem darin, dass durch Auswertung einer Bewegung der Warnvorrichtung im Bereich der unter Spannung stehenden Komponente, vor allem im Bereich einer elektrischen Leitung, und der während der Bewegung der Warnvorrichtung mittels des Messsignals erfassten Werte der Feldstärke des elektrischen Felds, das die Komponente umgibt, auf einfache und zuverlässige Weise eine gefährliche Annäherung und/oder ein Erreichen oder sogar Unterscheiten eines Sicherheitsabstands zur Komponente festgestellt werden kann. Wird ein derartiges Gefährdungspotential von der Warnvorrichtung ermittelt, so wird eine Ausgabe eines Warnsignals so gesteuert, dass ein Warnsignal erfolgt.

Daher ist die Auswerteeinheit der Warnvorrichtung idealerweise dazu eingerichtet, aus den vom Beschleunigungssensor erfassten Beschleunigungsdaten zumindest eine jeweils aktuelle Position der Warnvorrichtung in Bezug zu einer der jeweiligen aktuellen Position vorhergehende Position und eine zugehörige Veränderung des von der Sensoreinheit erfassten Messsignals zu ermitteln, und aus der Veränderung des Messsignals und einer Positionsveränderung der Warnvorrichtung zwischen der jeweils ermittelten aktuellen Position in Bezug zur jeweils vorhergehenden Position das jeweilige Gefährdungspotential abzuschätzen.

Es ist weiterhin vorteilhaft, wenn die Auswerteeinheit dazu eingerichtet ist, aus der Positionsveränderung der Warnvorrichtung, und der zugehörigen Veränderung des Messsignals, eine Höhe der Spannung der Komponente sowie einen jeweils aktuellen Abstand der Warnvorrichtung zur Komponente zu abzuschätzen. Die jeweils abgeschätzte Höhe der Spannung der Komponente sowie der jeweils aktuelle Abstand können in vorteilhafter Weise dazu verwendet werden, das Gefährdungspotential durch die Komponente der elektrischen Anlage noch besser und genauer abzuschätzen. Dadurch kann sehr einfach festgestellt werden, ob es das erfasste elektrische Feld beispielsweise um eine Komponente des Niederspannungsbereichs mit geringem Abstand zur Warnvorrichtung oder um eine weit entfernte Komponente des Mittel- oder Hochspannungsbereichs handelt. Dementsprechend kann dann die Ausgabe des Warnsignals sehr leicht angepasst werden.

Außerdem ist es günstig, wenn die Auswerteeinrichtung dazu eingerichtet ist, das jeweils abgeschätzte Gefährdungspotential auszuwerten, und anhand eines Auswerteergebnisses die Ausgabe des zumindest einen Warnsignals zu aktivieren oder zu deaktivieren, wobei die Ausgabe des Warnsignals an das jeweils abgeschätzte Gefährdungspotential angepasst ist. Dabei kann das jeweils abgeschätzte Gefährdungspotential idealerweise mit vorgegebenen Schwellwert verglichen werden, um z.B. bei Überschreiten des Schwellwerts die Ausgabe des Warnsignals zu aktivieren.

Eine bevorzugte Ausführungsform der Warnvorrichtung sieht vor, dass Warnvorrichtung eine Alarmierungseinheit zur Ausgabe des zumindest einen Warnsignals aufweist. Dabei kann das zumindest eine Warnsignal von der Alarmierungseinheit als optischer Alarm und/oder akustischer Alarm und/oder Vibrationsalarm ausgegeben werden. Durch die Ansteuerung der Auswerteeinheit ist beispielsweise eine Lautstärke und/oder eine Frequenz und/oder eine Intensität des zumindest einen Warnsignals bei der Ausgabe an das jeweils abgeschätzte Gefährdungspotential anpassbar.

Es ist auch vorteilhaft, wenn die Warnvorrichtung eine lokale Speichereinheit aufweist, in welcher zumindest Anpassungsvorgaben zum Anpassen der Ausgabe des zumindest einen Warnsignals an das jeweils abgeschätzte Gefährdungspotential sowie der zumindest eine Schwellwert für das elektrische Feld hinterlegt sind. Die Auswerteeinheit kann dabei z.B. zum Anpassen der Ausgabe des zumindest einen Warnsignals an das jeweils abgeschätzte Gefährdungspotential auf in der Speichereinheit hinterlegte Anpassungsvorgaben für das Warnsignal (z.B. betreffend Frequenz, Lautstärke, Intensität, etc.) heranziehen und die Ausgabe des Warnsignals durch Alarmierungseinheit damit sehr leicht und einfach ansteuern.

Eine zweckmäßige Ausgestaltung der Warnvorrichtung sieht vor, dass die Warnvorrichtung als mobiles Gerät ausgestaltet ist, welches an einem Helm oder an einem Kleidungsstück anbringbar ist oder am Handgelenk tragbar ist. Die Warnvorrichtung kann damit sehr einfach von einer Person z.B. bei Wartungs-, Reparatur- oder Inspektionsarbeiten im Bereich einer elektrischen Anlage bzw. einer Komponente einer elektrischen Anlage, insbesondere einer elektrischen Leitung, verwendet werden, um bei einer Gefährdung frühzeitig und zuverlässig gewarnt zu werden. Alternativ kann die als mobiles Gerät ausgestaltete Warnvorrichtung derart ausgestaltet ist, dass die Warnvorrichtung an einer Arbeitsmaschine anbringbar ist. Damit kann z.B. eine zu nahe Annäherung einer Arbeitsmaschine (z.B. Kran, Bagger, etc.) an die Komponente, insbesondere elektrische Leitung, rechtzeitig erkannt und gegebenfalls eine Beschädigung der Komponente und/oder der Arbeitsmaschine verhindert werden.

### Kurzbeschreibung der Figuren

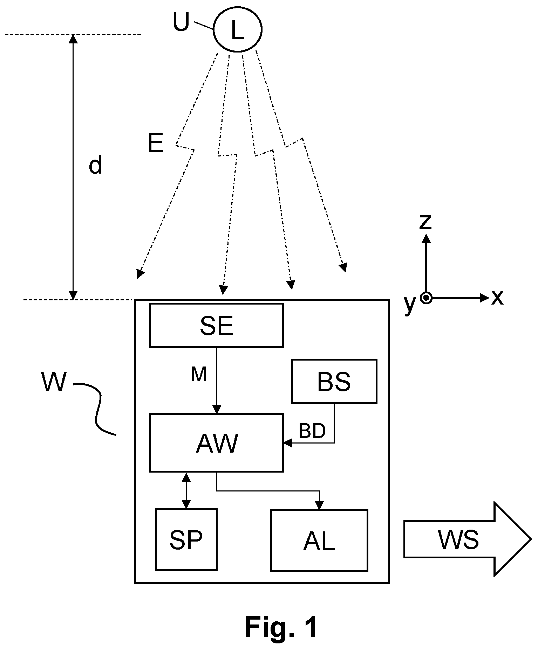

Die gegenständliche Erfindung wird nachfolgend unter Bezugnahme auf die Figur 1 näher erläutert, die beispielhaft, schematisch und nicht einschränkend eine vorteilhafte Ausgestaltung der Erfindung zeigen. Dabei zeigt Fig.1 eine Ausführungsform der erfindungsgemäßen Warnvorrichtung zum Erkennen einer Annäherung an eine elektrische Anlage mit zumindest einer Komponente.

### Ausführung der Erfindung

Die Erfindung betrifft eine Warnvorrichtung W, mit welcher eine Annäherung an eine elektrische Anlage eines Energieversorgungssystems bzw. an eine unter Spannung U stehende Komponente L einer elektrischen Anlage eines Energieversorgungssystems erkannt werden kann.

In Fig. 1 ist beispielhaft als Komponente L, welche unter einer Spannung U steht und daher von einem elektrischen Feld E umgeben ist, eine elektrische Leitung oder ein elektrische Leitersystem, wie z.B. ein Kabel oder eine Freileitung, oder ein Abschnitt davon im Querschnitt dargestellt. Die Spannung U kann in einem unterschiedlichen Spannungsbereich liegen, je nachdem ob die elektrische Leitung zu einer elektrischen Anlage bzw. einem Übertragungs- und/oder Verteilungsnetz im Hoch-, Mittel- oder Niederspannungsbereich gehört. Bei einer Leitung oder einem Leitungssystem des Niederspannungsbereichs, welches z.B. aus drei Außenleitern und einem Neutral- und einem Schutzleiter besteht, liegt die Spannung U beispielsweise in einem Bereich von 230V bis 400V, je nachdem ob die Spannung U von einem Außenleiter gegen Neutral- und Schutzleiter oder die Spannung U zwischen zwei Außenleitern betrachtet wird, kann aber bis zu ca. 1kV betragen. Bei einer Leitung eines Mittelspannungsnetzes kann die Spannung U zwischen den Außenleitern beispielsweise in einem Bereich von 1kV bis zu ca. 50kV bis 60kV liegen, wobei z.B. Mittelspannungsnetze zur Übertragung und Verteilung von Energie üblicherweise mit z.B. 10kV oder 20kV betrieben werden. Handelt es sich um eine Leitung eines Hochspannungsnetzes so kann die Spannung U zwischen den Außenleitern in einem Bereich von ca. 50kV oder 60kV bis zu über 400kV liegen, wobei z.B. Hochspannungsnetz in Westeuropa üblicherweise mit 110kV, 220kV oder 380kV, gelegentlich mit 420kV betrieben werden.

Die Warnvorrichtung W kann aber auch im Umfeld einer anderen Komponente L einer elektrischen Anlage, wie z.B. eines Transformators, einer Schaltanlage, etc., welche von einem elektrischen Feld E umgeben ist, zum Erkennen einer gefährlichen Annäherung eingesetzt werden.

Bei Annäherung an die unter Spannung U stehende Komponente, z.B. eine elektrische Leitung oder bei Verringerung eines Abstands d zur Komponente L, beispielsweise im Rahmen von Wartungs-, Reparatur- und/oder Inspektionsarbeiten, besteht ein Gefährdungspotential durch die Komponente L, z.B. dass eine Person der Komponente L zu nahekommt, einen Stromschlag erleidet oder gegebenenfalls die Komponente L, insbesondere eine elektrische Leitung, unabsichtlich berührt. Auch bei einem Einsatz von Arbeitsmaschinen (z.B. Kran, Bagger, etc.) kann das Gefährdungspotential bestehen, z.B. der Komponente L zu nahe zu kommen, was zu Beschädigungen an der Komponente L und/oder der Arbeitsmaschine, zu einem Kurzschluss und zu Störungen in der elektrischen Anlage, etc. führen kann. Daher ist es wichtig, dass sowohl von Personen als auch Arbeitsmaschinen ein gewisser Sicherheitsabstand zur Komponente L eingehalten wird, um eine Gefährdung (z.B. Stromschlag, unabsichtliche Berührung, Beschädigung, etc.) möglichst gering zu halten. Je nachdem in welchem Spannungsbereich - d.h., Nieder-, Mittel- oder Hochspannung - die Höhe der Spannung U der Komponente L liegt, kann ein unterschiedlich großer Sicherheitsabstand notwendig sein. Bei elektrischen Leitungen kann dieser Sicherheitsabstand z.B. bei einer Leitung im Niederspannungsbereich mit einer Spannung U von 230V bzw. 400V ca. 0,5m, bei z.B. einer Leitung im Mittelspannungsbereich mit einer Spannung U von 10kV zwischen den Leitern ca. 1,5m oder bei einer Leitung im Hochspannungsbereich mit einer Spannung U von 420kV zwischen den Leitern ca. 5m betragen. Bei Annäherung an die Komponente L, vor allem wenn ein Abstand d zur Komponente L diesen Sicherheitsabstand erreicht oder gar unterschreitet, steigt das Gefährdungspotential für eine Person durch die Komponente L bzw. für eine Beschädigung und/oder Störung der Komponente L durch eine Arbeitsmaschine an.

Die in Fig. 1 beispielhaft und schematische dargestellte Warnvorrichtung W befindet sich in einem Umfeld der unter Spannung U stehenden Komponente L, wie z.B. einer elektrischen Leitung, und wird dort z.B. durch die Person, die die Warnvorrichtung W trägt, oder eine Arbeitsmaschine, an welcher die Warnvorrichtung W angebracht ist, in einem Referenzkoordinatensystem mit einer x-Achse, einer y-Achse und einer z-Achse bewegt. Dabei wird beispielsweise das Referenzkoordinatensystem so angenommen, dass eine von der x-Achse und y-Achse gebildete Ebene parallel zur Komponente L und die z-Achse z normal zur Komponente L ausgerichtet ist. D.h., dass beispielsweise eine Bewegung der Warnvorrichtung W in Richtung der x-Achse oder y-Achse der Abstand d zur Komponente L weitgehend gleichbleibt, während sich der Abstand d zur Komponente L bei einer Bewegung der Warnvorrichtung W, welche einen Anteil in Richtung der z-Achse aufweist, verändert, z.B. kleiner oder größer wird.

Die in Fig. 1 beispielhaft und schematisch dargestellte Warnvorrichtung W ist daher dazu eingerichtet, während einer Annäherung an die Komponente L (d.h., bei einer Bewegung der Warnvorrichtung W mit Anteil in Richtung der z-Achse) vor dem Gefährdungspotential durch die Komponente L, vor allem vor Erreichen oder Unterschreiten eines Sicherheitsabstands, zu warnen - unabhängig davon in welchem Spannungsbereich die Höhe der Spannung U der unter Spannung U stehenden Komponente L liegt. Dazu weist die Warnvorrichtung W, wie beispielhaft in Fig. 1 dargestellt, eine Sensoreinheit SE auf, welche das elektrische Feld E, das die Komponente L umgibt, in Form eines Messsignals M beispielsweise laufend ab Aktivierung bzw. Einschalten der Warnvorrichtung W erfasst.

Die Sensoreinheit SE kann dazu zumindest einen Sensor, üblicherweise mehrere Sensoren umfassen, um das elektrische Feld E omnidirektional detektieren zu können. Mittels des zumindest einen Sensors kann die Sensoreinheit SE das die Komponente L umgebende, elektrische Feld E erfassen und damit eine Stärke und ein Ausmaß des elektrischen Felds E erkennen. Der zumindest eine Sensor der Sensoreinheit SE kann z.B. als kapazitiver Sensor ausgeführt sein, welcher beispielsweise aus zwei im Raum angeordneten Leitern (z.B. Plättchen aus leitendem Material) besteht, zwischen denen eine Spannung gemessen wird. Das von der Sensoreinheit SE erfasste Messsignal M werden dann - gegebenenfalls nach einer entsprechenden Verstärkung durch eine Verstärkereinheit - an eine Auswerteeinheit AW der Warnvorrichtung W übermittelt.

Weiterhin kann die Warnvorrichtung W einen Beschleunigungssensor BS aufweisen, welcher, wie beispielhaft in Fig. 1 dargestellt, in die Warnvorrichtung W integriert ist. Der Beschleunigungssensor BS kann aber auch als separater Bauteil vorliegen und mit der Auswerteeinheit AW der Warnvorrichtung W in geeigneter Weise verbunden sein. Mit dem Beschleunigungssensor BS kann eine Bewegung bzw. eine Positionsveränderung der Warnvorrichtung W im Referenzkoordinatensystem erkannt werden, welche z.B. eine die Warnrichtung W tragende Person oder durch eine Arbeitsmaschine, auf der die Warnvorrichtung W angebracht wird, bewirkt wird. Der Beschleunigungssensor BS erfasst eine Beschleunigung der Warnvorrichtung W, vorzugsweise im 3-dimensionalen Raum, z.B. in Form von Beschleunigungsdaten BD und liefert dabei z.B. drei lineare Beschleunigungswerte für eine translatorische Bewegung in den drei Raumrichtungen, kann aber auch oder zusätzlich drei rotatorische Beschleunigungswerte für rotatorische Bewegungen liefern. Daraus kann eine lineare Beschleunigung im Raum ermittelt werden, aber auch alternativ oder zusätzlich ein rotativer Beschleunigungszustand. Die Beschleunigung wird üblicherweise auf eine Referenzlage oder Referenzorientierung bezogen, beispielsweise auf das Referenzkoordinatensystem.

Der Beschleunigungssensor BS ist vorteilhaft als so genannte inertiale Messeinheit ausgeführt, welche als Messwerte bzw. Beschleunigungsdaten BD drei lineare Beschleunigungswerte für die translatorische Bewegung und drei Winkelgeschwindigkeiten für die Drehraten einer Person oder Arbeitsmaschine, an welcher die Warnvorrichtung 1 angeordnet ist. Aus diesen Beschleunigungsdaten BD kann auch eine Geschwindigkeit der Person oder Arbeitsmaschine im Raum (beispielsweise durch Integration der linearen Beschleunigungen), eine Position der Person oder Arbeitsmaschine im Raum (beispielsweise durch zweimalige Integration der linearen Beschleunigungen) und/oder eine Orientierung der Person oder Arbeitsmaschine im Raum (durch Integration der Winkelgeschwindigkeiten) ermittelt werden, um z.B. Positionen der Warnvorrichtung W und damit eine Positionsveränderung der Warnvorrichtung W im Raum abschätzen zu können. Die vom Beschleunigungssensor BS ermittelten, die Position und/oder Positionsveränderung der Warnvorrichtung W beschreibenden Beschleunigungsdaten BD werden an die Auswerteeinheit AW übermittelt.

Die Auswerteeinheit AW ist dazu eingerichtet, einerseits die vom Beschleunigungssensor BS erfassten Beschleunigungsdaten BD und andererseits das von der Sensoreinheit SE erfasste Messsignal M auszuwerten.

Aus dieser Auswertung schätzt die Auswerteeinheit AW ein jeweiliges Gefährdungspotential, beispielsweise für eine Person durch die Komponente L bzw. für eine Beschädigung und/oder Störung der Komponente L durch eine Arbeitsmaschine, ab.

Dazu kann die Auswerteeinheit AW aus den vom Beschleunigungssensor BS erfassten Beschleunigungsdaten BD zumindest eine jeweils aktuelle Position der Warnvorrichtung W in Bezug zu einer dieser Position vorhergehenden Position der Warnvorrichtung W abschätzen. Das bedeutet, es können von der Auswerteeinheit AW aus den Beschleunigungsdaten BD immer nur relative Positionen der Warnvorrichtung W ermittelt werden, wobei die die jeweils aktuelle Position im Vergleich zu einer vorhergehenden bzw. früheren Position ermittelt wird. Es werden von der Auswerteeinheit AW anhand der Beschleunigungsdaten BD immer nur Positionsveränderungen - zwischen der jeweils aktuellen Position und einer vorhergehenden Position - betrachtet.

Zu diesen Positionsveränderungen der Warnvorrichtung W - von der jeweils vorhergehenden Position zur jeweils aktuellen Position - ermittelt die Auswerteeinheit AW jeweils zugehörige Veränderungen des Messsignals M, mit welchem die Sensoreinheit SE das elektrische Feld E erfasst. D.h., die Auswerteeinheit AW ermittelt eine Positionsveränderung der Warnvorrichtung W im Bereich der Komponente L und die zugehörige Veränderung der gemessenen Feldstärke E bei der ermittelten Positionsveränderung, um daraus das jeweilige Gefährdungspotential abzuschätzen. Für die Abschätzung des jeweiligen Gefährdungspotentials kann z.B. die Veränderung des Messsignals M bzw. der gemessenen Feldstärke in Relation zur Positionsveränderung gesetzt werden. Das bedeutet, ist beispielsweise die Veränderung des Messsignals M in Relation zur Positionsveränderung der Warnvorrichtung W groß, so kann von einem relativ hohen Gefährdungspotential ausgegangen werden. Die Auswerteeinheit AW schätzt daher ein großes Gefährdungspotential (z.B. die Komponente K ist der Warnvorrichtung W ziemlich nahe) ab und steuert die Ausgabe des Warnsignals WS entsprechend an. Ist allerdings beispielsweise die Veränderung des Messsignals M bzw. der gemessenen Feldstärke in Relation zur Positionsveränderung gering oder sogar sehr gering, so kann von einem niedrigen bis sehr niedrigen Gefährdungspotential ausgegangen werden. Die Auswerteeinheit AW schätzt daher ein kleines bzw. sehr kleines Gefährdungspotential (z.B. die Komponente K ist von der Warnvorrichtung W entfernt oder weit entfernt) ab und steuert ebenfalls die Ausgabe des Warnsignals WS entsprechend an.

Die Warnvorrichtung W bzw. die Auswerteeinheit AW stellt beim Abschätzen des jeweiligen Gefährdungspotentials, wie oben angeführt, eine Relation zwischen der Positionsveränderung zwischen zwei relativen Positionen der Warnvorrichtung W und der Veränderung des Messsignals M bzw. der gemessenen Feldstärkenwerte an den zwei relativen Positionen der Warnvorrichtung W her. Es könnte beispielsweise eine Differenz der gemessenen Feldstärkenwerte an den jeweiligen relativen Positionen durch die Positionsveränderung (= Abstand zwischen den zwei relativen Positionen) dividiert werden.

In der Auswerteeinheit AW kann z.B. für die Abschätzung des Gefährdungspotentials angenommen werden, dass z.B. zu einem ersten Zeitpunkt das Messsignal M einen ersten Feldstärkenwert und zu einem zweiten Zeitpunkt einen zweiten Feldstärkenwert aufweist. Mittels des Beschleunigungssensors BS kann ermittelt werden, dass sich die Position der Warnvorrichtung zwischen dem ersten Zeitpunkt und dem zweiten Zeitpunkt um 50mm verändert.

Handelt es sich z.B. bei der Komponente L der elektrischen Anlage z.B. um eine elektrische Leitung des Niederspannungsbereichs (d.h. z.B. mit einer Nennspannung von 400V bzw. 230V gegen Erde) und hätte die Warnvorrichtung W z.B. zum ersten Zeitpunkt eine Abstand d von z.B. 250mm zur Leitung und wäre z.B. zum zweiten Zeitpunkt um 50mm näher bei der Leitung (Abstand d = 200mm), so würde die Warnvorrichtung W bzw. die Sensoreinheit SE - bei einer Annahme eines unendlich langer Leiter mit 240mm2 Querschnitt bzw. einem Radius R von z.B. 8,74mm, gemäß der Formel

$$E(d) = \frac{U}{d*\ln\left(\frac{d}{R}\right)},$$

wobei E für das elektrische Feld bzw. die elektrische Feldstärke, d für einen Abstand zum Spannung führenden Leiter, U für die Spannung und R für einen Radius des elektrischen Leiters stehen, zum ersten Zeitpunkt z.B. einen ersten Feldstärkewert als Wert des Messsignals M von 275,5 V/m messen. Zum zweiten Zeitpunkt würde das Messsignal z.B. einen zweiten Feldstärkewert von 368,9V/m liefern. Die Veränderung der beiden Feldstärkewerte in Relation zur Positionsveränderung der Warnvorrichtung W ergäbe somit beispielsweise etwa 1850 V als abgeschätztes Gefährdungspotential. Das bedeutet, ein relativ hohes Gefährdungspotential für z.B. eine Person, welche die Warnvorrichtung W trägt.

Wird z.B. angenommen, die Komponente L wäre z.B. eine elektrische Leitung mit z.B. 145kV, als z.B. aus dem Hochspannungsbereich, und die Warnvorrichtung W hätte z.B. zum ersten Zeitpunkt eine Abstand d von z.B. 28,03m zur Leitung und wäre z.B. zum zweiten Zeitpunkt um 50mm näher bei der Leitung (Abstand d = 28,08m), so würde die Sensoreinheit SE der Warnvorrichtung zum ersten Zeitpunkt gemäß der oben angeführten Formel beispielsweise ein Messsignal M mit einem Feldstärkewert von 368,9V/m messen, aber das Messsignal M würde zum zweiten Zeitpunkt einen nur geringfügig veränderten Feldstärkewert (z.B. 370,0V/m) aufweisen. Die Veränderung der beiden Feldstärkewerte in Relation zur Positionsveränderung der Warnvorrichtung W ergäbe somit beispielsweise etwa 14,8V als abgeschätztes Gefährdungspotential. Das deutet z.B. darauf hin, dass der Abstand von ca. 28m zur 145kV-Leitung mehr als ausreichend ist. Erst bei einem wesentlich geringen Abstand zur Leitung (z.B. bei ca. 3m) würde beispielsweise ein Gefährdungspotential einer Größenordnung wie bei der oben angeführten Niederspannungsleitung auftreten.

Für die Abschätzung des Gefährdungspotentials können in der Auswerteeinheit AW beispielsweise Tabellen verwendet werden. Es kann aber auch anhand von Formel rechnerisch abgeschätzt werden.

Weiterhin ist die Auswerteeinheit AW idealerweise auch dazu eingerichtet, aus der Positionsveränderung der Warnvorrichtung W und der zugehörigen Veränderung des Messsignals M die Höhe der Spannung U der unter der Spannung U stehenden Komponente L sowie einen jeweils aktuellen Abstand d der Warnvorrichtung W zur Komponente L zu abzuschätzen. Die abgeschätzte Höhe der Spannung U kann beispielsweise zur Anpassung sowie jeweils ermittelte, aktuelle Abstand d der Warnvorrichtung W kann dazu genutzt werden, das Gefährdungspotential noch besser und genauer abzuschätzen. Die Ausgabe des Warnsignals WS kann dann noch besser an das bestehende Gefährdungspotential angepasst werden.

Für diese Schätzung der Spannung U und des Abstands d kann z.B. bei einer elektrischen Leitung wieder die folgende Formel herangezogen werden:

$$E(d) = \frac{U}{d * \ln\left(\frac{d}{R}\right)},$$

wobei E für das elektrische Feld bzw. die elektrische Feldstärke, d für einen Abstand zum Spannung führenden Leiter, U für die Spannung und R für einen Radius des elektrischen Leiters stehen. Wird z.B. angenommen, dass ein typischer Leitungsquerschnitt (und damit Radius R des Leiters) vorliegt und, dass z.B. im gewählten Koordinatensystem bzw. Referenzkoordinatensystem die Positionsveränderung in x- bzw. y-Richtung annähernd gleichbleiben und die Positionsveränderung der Warnvorrichtung W einer Veränderung in z-Richtung entspricht, so kann anhand der Formel ein Gleichungssystem aufgestellt werden, aus welchen sich z.B. die unbekannte Spannung U (der Komponente L) und ein Abstand d zur Komponente L abschätzen lassen. Äquivalent könne bei Änderungen in allen drei Raumrichtungen ein entsprechend komplexeres Gleichungssystem aufgestellt werden, aus dem sich die Spannung U und der Abstand d abschätzen lässt.

Weiterhin kann die Auswerteeinheit AW dazu eingerichtet sein, das jeweils abgeschätzte Gefährdungspotential auszuwerten. Anhand eines Auswerteergebnisses ermittelt die Auswerteeinheit AW, ob die Ausgabe des zumindest einen Warnsignals (WS) zu aktivieren oder zu deaktivieren ist. Dabei kann die Ausgabe des Warnsignals WS an das jeweils abgeschätzte Gefährdungspotential angepasst sein. Für die Auswertung des jeweils abgeschätzten Gefährdungspotentials kann die Auswerteeinheit AW z.B. zumindest einen vorgegebenen Schwellwert (z.B. 1000V als Schwellwert zum Aktivieren bzw. Deaktivieren der Ausgabe des Warnsignals WS) verwenden.

Alternativ können auch mehrere Schwellwerte vorgesehen sein, welche z.B. in Abhängigkeit der geschätzten Höhe der Spannung U der Komponente L der Auswerteeinheit AW zum Aktivieren bzw. Deaktivieren der Ausgabe des Warnsignals WS vorgegeben werden. Das bedeutet, der Schwellwert kann von der Warnvorrichtung W dynamisch z.B. an einen jeweiligen Spannungsbereich (z.B., Nieder-, Mittel- oder Hochspannung) der Komponente L angepasst werden. Um den jeweiligen Schwellwert zu ermitteln, kann beispielsweise die Höhe der Spannung U aus der Positionsveränderung der Warnvorrichtung W, welche aus den Beschleunigungsdaten BD ermittelt wurde, und der zugehörigen Veränderung des Messsignals M des elektrischen Felds E abgeschätzt werden. Der zumindest eine vorgegebene Schwellwert bzw. die für z.B. unterschiedliche Spannungsbereich vorgegebenen Schwellwerte können z.B. in der Auswerteeinheit AW oder in einer lokalen Speichereinheit SP hinterlegt sein.

Die Auswerteeinheit AW vergleicht dann jeweils abgeschätzte Gefährdungspotential mit dem zumindest einen vorgegebenen Schwellwert. Bei Überschreiten des Schwellwerts durch das abgeschätzte Gefährdungspotential stellt die Auswerteeinheit AW fest, dass die Ausgabe des Warnsignal WS zu aktivieren ist, sofern das Warnsignal WS noch nicht ausgegeben wird. Bei Unterschreiten des Schwellwerts durch das abgeschätzte Gefährdungspotential kann die Auswerteeinheit AW die Ausgabe des Warnsignals WS dazu ansteuern, beispielsweise ein eingeschaltetes Warnsignal WS wieder auszuschalten.

Die Auswerteeinheit AW kann daher eine mikroprozessorbasierte Hardware sein, auf der entsprechende Software abläuft. Die Auswerteeinheit AW kann aber auch als integrierter Schaltkreis, wie als Field-Programmable Gate Array (FPGA) oder Anwendungsspezifische integrierte Schaltung (ASIC), ausgeführt sein. Auch andere Implementierungen sind grundsätzlich denkbar.

Weiterhin kann eine Alarmierungseinheit AL vorgesehen sein. Die Alarmierungseinheit AL ist dann dazu eingerichtet - angesteuert durch die Auswerteeinheit AW, ein entsprechend angepasstes Warnsignal WS abzusetzen, um entsprechend dem von der Auswerteeinheit AW abgeschätzten Gefährdungspotential zu warnen. Die Alarmierungseinheit AL kann beispielsweise das Warnsignal WS als optischer Alarm und/oder akustischer Alarm und/oder Vibrationsalarm ausgeben. Die Alarmierungseinheit AL kann dazu beispielsweise eine optische Anzeigeeinheit, wie z.B. eine LED oder ein kleines Display, aufweisen. Die LED oder das Display kann z.B. mit einer Frequenz blinken, welche die Auswerteeinheit AW mittels entsprechender Ansteuerung der Alarmierungseinheit AL an das abgeschätzte Gefährdungspotential durch die Komponente L anpasst. D.h., ermittelt die Auswerteeinheit AW beispielsweise ein hohes oder ein steigendes Gefährdungspotential durch die Komponente L, da sich z.B. die die Warnvorrichtung W tragende Person der Komponente L nähert oder bereits sehr nahe ist, dann wird die Frequenz des Blinkens der LED oder des Displays gesteigert. Reduziert sich das abgeschätzte Gefährdungspotential durch die Komponente L, da sich z.B. die Person von der Komponente L entfernt, so kann die Frequenz entsprechend reduziert werden oder gegebenenfalls der optische Alarm deaktiviert werden, bis wieder das abgeschätzte Gefährdungspotential wieder ansteigt.

Weiterhin kann die Alarmierungseinheit AL eine akustische Ausgabeeinheit, wie z.B. einen Lautsprecher, umfassen. Über die akustische Ausgabeeinheit kann z.B. ein akustischer Alarm, wie z.B. ein Warnton oder ein Pfeifsignal, ausgegeben werden. Analog dem optischen Alarm kann bei einem akustischen Alarm z.B. eine Lautstärke, eine Tonhöhe und/oder eine Wiederholungsfrequenz entsprechend dem abgeschätzten Gefährdungspotential durch die Komponente L angepasst werden. D.h., es kann die Lautstärke, die Tonhöhe und/oder die Wiederholungsfrequenz entsprechend dem jeweils abgeschätzten Gefährdungspotential verändert - z.B. bei steigendem oder hohen Gefährdungspotential gesteigert und bei sinkendem Gefährdungspotential reduziert werden. Bei sehr geringen abgeschätzten Gefährdungspotential besteht z.B. die Möglichkeit, den akustischen Alarm vorerst stummzuschalten.

Zusätzlich oder alternativ kann die Alarmierungseinheit AL beispielsweise auch einen Vibrationsmotor zur Ausgabe eines Vibrationsalarms aufweisen, wobei z.B. eine Frequenz und/oder Intensität des Vibrationsalarms an das jeweils abgeschätzte Gefährdungspotential über entsprechende Ansteuerung der Auswerteeinheit AW anpassbar ist.

Weiterhin kann die Warnvorrichtung W die lokale Speichereinheit SP aufweisen. In der lokalen Speichereinheit SP kann beispielsweise der zumindest eine vorgegebene Schwellwert für das erfasste elektrische Feld E hinterlegt sein. Weiterhin können beispielsweise in der lokalen Speichereinheit SP auch für unterschiedliche Spannungsbereich unterschiedliche Schwellwerte hinterlegt sein, um z.B. den Schwellwert zum Aktivierten bzw. Deaktivieren des Warnsignals WS an die Höhe der Spannung U der unter Spannung U stehenden Komponente L anzupassen.

Weiterhin können in der lokalen Speichereinheit SP auch Anpassungsvorgaben zur Anpassung des Warnsignals WS gespeichert sein. Dabei können beispielsweise in der Speichereinheit SP für unterschiedliche Größenbereiche für das abgeschätzte Gefährdungspotential - beispielsweise für die Veränderung des Messsignals M in Relation zu einer Positionsänderung der Warnvorrichtung W von einer vorhergehenden Position und einer aktuellen Position der Warnvorrichtung W - jeweils Anpassungsvorgaben für das Warnsignal WS hinterlegt sein. Durch dieses Anpassungsvorgaben kann das auszugebende Warnsignal WS z.B. in Lautstärke, Frequenz und/oder Intensität an das abgeschätzte Gefährdungspotential durch die Komponente L angepasst werden. Die Anpassungsvorgaben können z.B. in Form einer Tabelle in der Speichereinheit SP hinterlegt sein, wobei den vorgegebenen Größenbereichen jeweils eine Anpassungsvorgabe für das Warnsignal WS zugeordnet ist.

Weiterhin kann die Warnvorrichtung W eine Energieversorgung, wie z.B. eine entsprechende Batterie, einen entsprechenden Akkumulator oder Ähnliches, aufweisen. Die Energieversorgung versorgt dann vor allem die Auswerteeinheit AW sowie die Alarmierungseinheit AL mit der notwendigen Energie zu versorgen.

Weiterhin kann die Warnvorrichtung W als mobiles Gerät ausgestaltet sein. Dazu kann die Warnvorrichtung W ein Gehäuse aufweisen, in welchem zumindest die Sensoreinheit SE, die Auswerteeinheit AW, die Alarmierungseinheit AL, die lokale Speichereinheit SP sowie die Energieversorgung angeordnet sind. Der Beschleunigungssensor BS kann ebenfalls im Gehäuse der Warnvorrichtung W angeordnet sein. Alternativ kann der Beschleunigungssensor BS aber auch als separater Bauteil vorliegen und mit der Auswerteeinheit AW der Warnvorrichtung W in geeigneter Weise verbunden sein. Als mobiles Gerät kann die Warnvorrichtung W beispielsweise an einem Helm oder an einem Kleidungsstück angebracht werden oder am Handgelenk von einer Person getragen werden, um ein Gefährdungspotential der unter Spannung U stehenden Komponente L für die Person zu erkennen und die Person bei einer gefährlichen Annäherung (z.B. bei Erreichen oder Unterschreiten eines Sicherheitsabstands) zu warnen. Weiterhin kann die Warnvorrichtung W auch an einer Arbeitsmaschine, wie z.B. einem Kran oder an einem Bagger, insbesondere an einer Baggerschaufel, angeordnet sein, um zu erkennen, wenn die Arbeitsmaschine der Komponente L gefährlich nahekommt, zumindest ein Warnsignal WS abzusetzen und gegebenenfalls z.B. mittels eines Steuersignals der Auswerteeinheit AW der Warnvorrichtung W die Arbeitsmaschine zu stoppen.

Durch die Warnvorrichtung W wird beispielsweise erreicht, dass jeweils ein an das abgeschätzte Gefährdungspotential durch die Komponente L angepasstes Warnsignal WS ausgegeben wird. Weiterhin kann - vor allem durch Abschätzen der Höhe der Spannung U der Komponente L der Schwellwert zum Auslösen des Warnsignals dynamisch an den Spannungsbereich der Komponente L angepasste werden. Das bedeutet, dass z.B. bei einer Komponente L wie z.B. einer Leitung im Niederspannungsbereich (z.B. 230V/400V) z.B. ein Schwellwert zu Auslösen des Warnsignal WS verwendet werden kann, welcher z.B. sehr nahe bei der Leitung (z.B. bei ca. 1m) erreicht wird. Dabei wird aufgrund des hohen abgeschätzten Gefährdungspotentials die Ausgabe des Warnsignals WS so angesteuert, dass beispielsweise ein stark blinkender optischer Alarm und/oder ein lauter akustischer Alarm mit z.B. hoher Wiederholungsfrequenz und/oder Tonhöhe und/oder ein intensiver Vibrationsalarm ausgegeben wird.

Bei Verwendung desselben Schwellwerts beispielweise bei Annäherung an einen Komponente L, wie z.B. eine Leitung im Mittelspannungsbereich (z.B. 10kV) würde der Schwellwert z.B. bereits in einer relativ sicheren Distanz d zur Leitung erreicht werden. Damit ist das von der Warnvorrichtung W abgeschätzte Gefährdungspotential geringer und die Ausgabe des Warnsignal WS kann entsprechend dem abgeschätzten Gefährdungspotential angepasst werden. D.h., es wird z.B. ein langsamer blinkende optischer Alarm und/oder ein leiser akustischer Alarm mit z.B. geringerer Wiederholungsfrequenz und/oder Tonhöhe und/oder ein intensiver Vibrationsalarm ausgegeben als bei Erreichen des Schwellwerts bei Annäherung an eine Niederspannungsleitung. Bei einer weiteren Annäherung an die Mittelspannungsleitung kann dann z.B. die Warnsignalausgabe entsprechend durch z.B. Steigerung der Blinkfrequenz, der Lautstärke und/oder Wiederholungsfrequenz des akustischen Alarms und/oder der Intensität des Vibrationsalarms an ein Steigen des abgeschätzten Gefährdungspotentials angepasst werden. Zusätzlich könnte beispielsweise der Schwellwert zum Aktivieren der Ausgabe des Warnsignals an den Mittelspannungsbereich angepasst werden.

Bei Annäherung an eine Komponente L, wie z.B. eine Leitung im Hochspannungsbereich (z.B. 420kV) kann die Warnvorrichtung beispielsweise die Ausgabe des Warnsignals WS unterdrücken, da z.B. bei demselben Schwellwert wie für eine Niederspannungsleitung noch einen sichere Distanz d zur Leitung vorliegt und es erst mit weiterer Annäherung an die Leitung ausgeben. Zusätzlich könnte auch hier durch die Abschätzung der Höhe der Spannung U der auslösende Schwellwert entsprechend angepasst werden.

**Patentansprüche**

1. Warnvorrichtung (W) zum Erkennen einer Annäherung an eine elektrische Anlage, welche zumindest eine unter Spannung (U) stehende Komponente (L), insbesondere eine elektrische Leitung (L), die von einem elektrischen Feld (E) umgeben ist, aufweist, wobei die Warnvorrichtung (W) zumindest ausweist:

- eine Sensoreinheit (SE), welche das elektrische Feld (E) der zumindest einen Komponente (L) in ein Form eines Messsignals (M) erfasst;
- einen Beschleunigungssensor (BS), welcher eine Beschleunigung der Warnvorrichtung (W), vorzugsweise in einem 3-dimensionalen Raum, in Form von Beschleunigungsdaten erfasst; und
- eine Auswerteeinheit (AW), welche dazu eingerichtet ist, aus den vom Beschleunigungssensor (BS) erfassten Beschleunigungsdaten (BD) und aus dem von der Sensoreinheit (SE) erfassten Messsignal (M) ein jeweiliges Gefährdungspotential abzuschätzen, um zumindest eine Ausgabe von zumindest einem Warnsignal zu steuern, und welche weiterhin dazu eingerichtet ist, aus den vom Beschleunigungssensor (BD) erfassten Beschleunigungsdaten (BS) zumindest eine jeweils aktuelle Position der Warnvorrichtung (W) in Bezug zu einer der jeweiligen aktuellen Position vorhergehende Position und eine zugehörige Veränderung des von der Sensoreinheit (SE) erfassten Messsignals (M) zu ermitteln, und aus der Veränderung des Messsignals (M) und einer Positionsveränderung der Warnvorrichtung (W) zwischen der jeweils ermittelten aktuellen Position in Bezug zur jeweils vorhergehenden Position das jeweilige Gefährdungspotential abzuschätzen.

2. Warnvorrichtung (W) nach Anspruch 1, *dadurch gekennzeichnet, dass* die Auswerteeinheit (AW) dazu eingerichtet ist, aus der Positionsveränderung der Warnvorrichtung (W), und der zugehörigen Veränderung des Messsignals (M) eine Höhe der Spannung (U) der Komponente (L) sowie einen jeweils aktuellen Abstand (d) der Warnvorrichtung (W) zur Komponente (L) abzuschätzen.

3. Warnvorrichtung (W) nach einem der Ansprüche 1 bis 2, *dadurch gekennzeichnet, dass* die Auswerteeinrichtung (AW) dazu eingerichtet ist, das jeweils abgeschätzte Gefährdungspotential auszuwerten, und anhand eines Auswerteergebnisses die Ausgabe des zumindest einen Warnsignals (WS) zu aktivieren oder zu deaktivieren, wobei die Ausgabe des Warnsignals (WS) an das jeweils abgeschätzte Gefährdungspotential angepasst ist.

4. Warnvorrichtung (W) nach einem der Ansprüche 1 bis 3, *dadurch gekennzeichnet, dass* die Auswerteeinheit (AW) dazu eingerichtet ist, für eine Auswertung das jeweils abgeschätzte Gefährdungspotential mit einem vorgegebenen Schwellwert zu vergleichen.

5. Warnvorrichtung (W) nach einem der Ansprüche 1 bis 4, *dadurch gekennzeichnet, dass* die Warnvorrichtung (W) eine Alarmierungseinheit (AL) zur Ausgabe des zumindest einen Warnsignals (WS) aufweist, wobei die Alarmierungseinheit (AL) das zumindest eine Warnsignal (WS) als optischen Alarm und/oder akustischen Alarm und/oder Vibrationsalarm ausgibt, und wobei mittels Ansteuerung durch die Auswerteeinheit (AW) eine Lautstärke und/oder Frequenz und/oder Intensität des zumindest einen Warnsignals (WS) bei der Ausgabe an das jeweils abgeschätzte Gefährdungspotential angepasst ist.

6. Warnvorrichtung (W) nach einem der Ansprüche 1 bis 5, *dadurch gekennzeichnet, dass* die Warnvorrichtung (W) eine lokale Speichereinheit (SP) aufweist, in welcher zumindest Anpassungsvorgaben zum Anpassen der Ausgabe des zumindest einen Warnsignals (WS) an das jeweils abgeschätzte Gefährdungspotential sowie der zumindest eine Schwellwert für das elektrische Feld (E) hinterlegt sind.

7. Warnvorrichtung (W) nach einem der Ansprüche 1 bis 6, *dadurch gekennzeichnet, dass* die Warnvorrichtung (W) als mobiles Gerät ausgestaltet ist, welches an einem Helm oder an einem Kleidungsstück anbringbar ist oder am Handgelenk tragbar ist, oder welches derart ausgestaltet ist, dass die Warnvorrichtung (W) an einer Arbeitsmaschine anbringbar ist.

**Fig. 1**

Europäisches Patentamt
European Patent Office
Office européen des brevets

# EUROPÄISCHER RECHERCHENBERICHT

Nummer der Anmeldung

EP 25 20 3269

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | CN 105 448 035 A (ELECTRIC POWER RES INST YUNNAN POWER GRID CO LTD) 30. März 2016 (2016-03-30) * Absätze [0051] - [0060], [0071] - [0076], [0078] * * Abbildungen 1,2,5 * ----- | 1-7 | INV. G08B21/02 |
| X | WO 2022/020882 A1 (PROTECTIVE INNOVATIONS PTY LTD [AU]) 3. Februar 2022 (2022-02-03) * Absätze [0040] - [0042], [0045], [0046], [0069] - [0072], [0078] * * Abbildungen 1,2 * ----- | 1-7 | |
| X | CN 109 374 991 A (XUZHOU POWER SUPPLY BRANCH CO STATE GRID JIANGSU ELECTRIC POWER CO LTD) 22. Februar 2019 (2019-02-22) * Absätze [0015], [0029] - [0042] * * Abbildung 1 * ----- | 1-7 | |
| X | EP 3 144 686 A1 (SOFAMEL SL [ES]) 22. März 2017 (2017-03-22) * Absätze [0006], [0018], [0024], [0025], [0028] - [0030], [0033] * * Abbildungen 1,2 * ----- | 1-7 | RECHERCHIERTE SACHGEBIETE (IPC) G08B G01R |
| A | EP 4 276 478 A1 (EMERSON PROFESSIONAL TOOLS LLC [US]) 15. November 2023 (2023-11-15) * Absätze [0022], [0023] * ----- | 3,5 | |

Der vorliegende Recherchenbericht wurde für alle Patentansprüche erstellt

| Recherchenort | Abschlußdatum der Recherche | Prüfer |
|---|---|---|
| München | 20. November 2025 | Meister, Mark |

EPO FORM 1503 03.82 (P04C03)

EP 4 715 775 A1

## ANHANG ZUM EUROPÄISCHEN RECHERCHENBERICHT
## ÜBER DIE EUROPÄISCHE PATENTANMELDUNG NR.

EP 25 20 3269

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-11-2025

| Im Recherchenbericht angeführtes Patentdokument | Datum der Veröffentlichung | Mitglied(er) der Patentfamilie | Datum der Veröffentlichung |
|---|---|---|---|
| CN 105448035 A | 30-03-2016 | KEINE | |
| WO 2022020882 A1 | 03-02-2022 | AU 2021317742 A1 | 02-03-2023 |
| | | CA 3187554 A1 | 03-02-2022 |
| | | EP 4188738 A1 | 07-06-2023 |
| | | JP 2023542271 A | 06-10-2023 |
| | | US 2023401949 A1 | 14-12-2023 |
| | | WO 2022020882 A1 | 03-02-2022 |
| CN 109374991 A | 22-02-2019 | KEINE | |
| EP 3144686 A1 | 22-03-2017 | KEINE | |
| EP 4276478 A1 | 15-11-2023 | CN 117054760 A | 14-11-2023 |
| | | EP 4276478 A1 | 15-11-2023 |
| | | US 2023366919 A1 | 16-11-2023 |

EPO FORM P0461

Für nähere Einzelheiten zu diesem Anhang : siehe Amtsblatt des Europäischen Patentamts, Nr.12/82

14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1296150 A1
- EP 4276478 A1
- WO 2018111474 A1